# EUROPÄISCHE PATENTANMELDUNG

(11) **EP 1 158 673 A2**
(43) Veröffentlichungstag der Anmeldung: **28.11.2001**
(21) Anmeldenummer: 01112025.0
(22) Anmeldetag: 23.05.2001
(51) Int. Cl.: H03H 11/12

(54) **Filteranordnung**

(30) Priorität: 26.05.2000 DE 10026161
(71) Anmelder: Philips Corporate Intellectual Property GmbH, 52064 Aachen (DE); Koninklijke Philips Electronics N.V., 5621 BA Eindhoven (NL)
(72) Erfinder: Van der Woude, Wim, Philips Corporate, 52064 Aachen (DE); Ruitenburg, Leonardus, Philips Corporate, 52064 Aachen (DE)
(74) Vertreter: Volmer, Georg, Dipl.-Ing.

(57) **Zusammenfassung**

Die Erfindung betrifft eine Filteranordnung mit einem lokalen Oszillator (4), mit Bandpassfiltern (1, 2) und mit einem Mischer (3). Die neuartige Filteranordnung zeichnet sich dadurch aus, dass zwei Bandpassfilter (1, 2) mit gleicher Bandbreite f_{B} und Mittenfrequenz f_{C} vorgesehen sind, wobei der Ausgang des ersten Bandpassfilters (1) mit dem Eingang des zweiten Bandpassfilters (2) mittels eines Mischers (3) gekoppelt ist und der lokale Oszillator (4) zur Steuerung des Mischers (3) vorgesehen ist.

## Beschreibung

Die vorliegende Erfindung betrifft eine Filteranordnung mit einem lokalen Oszillator, mit Bandpassfiltern und mit einem Mischer.

Aus der Schrift WO 95/12953 ist ein Satellitenempfänger mit einer Filteranordnung zur Variation der Bandbreite bei der Vorselektion des Empfangssignals bekannt. Die Filteranordnung besteht unter anderem aus zwei Bandpassfiltern, zwei Mischern und zwei lokalen Oszillatoren.

Aufgabe der vorliegenden Erfindung ist es, eine Filteranordnung mit variabler Bandbreite und variabler Mittenfrequenz des Ausgangssignals zu schaffen, welche mit möglichst wenigen, kostengünstigen Bauelementen auskommt.

Die Aufgabe wird erfindungsgemäß dadurch gelöst, dass zwei Bandpassfilter mit gleicher Bandbreite und Mittenfrequenz vorgesehen sind, wobei der Ausgang des ersten Bandpassfilters mit dem Eingang des zweiten Bandpassfilters mittels eines Mischers gekoppelt ist und der lokale Oszillator zur Steuerung des Mischers vorgesehen ist.
Diese Anordnung zeichnet sich durch einen besonders einfachen Aufbau aus, da nur ein Mischer und zwei gleichartige Bandpassfilter benötigt werden.

Die Ausgestaltungen nach Anspruch 2 ermöglichen es, die Eigenschaften der gekoppelten Bandpassfilter und damit der gesamten Filteranordnung zu verändern. Da der lokale Oszillator ein Ausgangssignal mit einer variabel einstellbaren Frequenz abgibt, lässt sich durch einfaches Verändern der Frequenz des Ausgangssignals des lokalen Oszillators die Bandbreite und die Mittenfrequenz des Ausgangssignals der gesamten Filteranordnung bestimmen.

Bei der Ausgestaltung nach Anspruch 3 werden die Vorzüge der Filteranordnung für Quadraturamplitudenmodulation (QAM) nutzbar gemacht. Durch die veränderliche Mittenfrequenz des Ausgangssignals der Filteranordnung ist diese hervorragend geeignet, die Zwischenfrequenz besonders bei Schmalband-QAM zu variieren.

Die Ausgestaltung nach Anspruch 4 sorgt für einen besonders kostengünstigen Aufbau der Filteranordnung, da beide Filter identisch aufgebaut sind und zudem eine feste unveränderbare Bandbreite aufweisen.

Ein Ausführungsbeispiel der Erfindung wird nachfolgend an Hand zweier Figuren näher erläutert. Es zeigen:
- Figur 1: den Aufbau der erfindungsgemäßen Filteranordnung und
- Figur 2: eine Frequenztabelle der erfindungsgemäßen Filteranordnung.

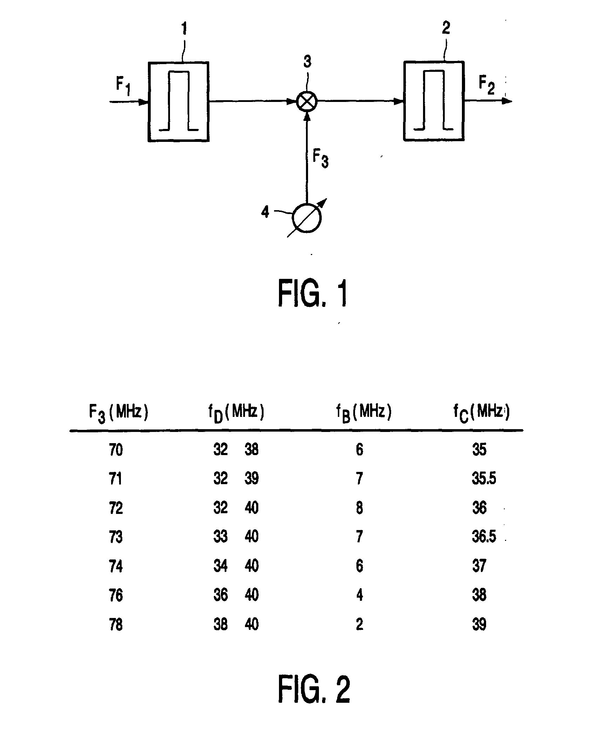

Die in Figur 1 gezeigte Filteranordnung weist als Bauelemente ein erstes Bandpassfilter 1, ein zweites Bandpassfilter 2, einen Mischer 3 und einen lokalen Oszillator 4 auf. Diese Filteranordnung wird mit einem Eingangssignal F₁ beaufschlagt und gibt ein Ausgangssignal F₂ aus. Ziel der Anordnung ist es die Bandbreite f_{B} und die Mittenfrequenz f_{C} des Ausgangssignals F₂ zu variieren. Dazu wird das Eingangssignal F₁ dem ersten Bandpassfilter 1 zugeführt, dessen Ausgang über den Mischer 3 mit dem Eingang des zweiten Bandpassfilters 2 verbunden ist. Der Mischer 3 wird dabei mit dem Ausgangssignal F₃ des lokalen Oszillators 4 mit einer variablen Frequenz versorgt. Wird die Frequenz des lokalen Oszillators 4 verändert und die Parameter der beiden Bandpassfilter 1, 2 unverändert belassen, so verändert sich die Mittenfrequenz f_{C} des Ausgangssignals F₂. Gleichzeitig verändert sich damit aber auch die Bandbreite f_{B} des Ausgangssignals F₂. Um möglichst viele gleichartige standardisierte Bauteile zu verwenden, sind die beiden Bandpassfilter 1, 2 identisch und besitzen eine feste Bandbreite f_{B}. Das sorgt für einen besonders kostengünstigen Aufbau der gesamten Filteranordnung.

Figur 2 zeigt, wie sich Bandbreite und Mittenfrequenz verändern, wenn die eingespeiste Frequenz des Oszillators 4 variiert wird. Dabei wird die Frequenz des Ausgangssignals F₃ des lokalen Oszillators 4 zwischen 70 MHz und 78 MHz variiert. Die Durchlassfrequenzen f_{D} der beiden Bandpassfilter 1, 2 liegen jeweils zwischen 32 MHz und 40 MHz. Damit ergeben sich Bandbreiten f_{B} des Ausgangssignals F₂ von 2 MHz bis 8 MHz. Die Mittenfrequenzen f_{C} liegen zwischen 35 MHz und 39 MHz.

Der Einsatz dieser einfach aufgebauten Filteranordnung ist auch für die Abstimmung der Zwischenfrequenz bei Quadraturamplitudenmodulation (QAM) geeignet, wenn der Mischer eine ausreichende Störfestigkeit aufweist. So lässt sich die QAM, welche z.B. in Tunern und sogenannten Set-Top-Boxen für digitales Fernsehen eingesetzt wird, mit wenigen Bauteilen kostengünstig realisieren, was besonders bei einer Produktion in hohen Stückzahlen ein großer Vorteil ist.

## Patentansprüche

1. Filteranordnung mit einem lokalen Oszillator (4), mit Bandpassfiltern (1, 2) und mit einem Mischer (3),
**dadurch gekennzeichnet,**
**dass** zwei Bandpassfilter (1, 2) mit gleicher Bandbreite f_{B} und Mittenfrequenz f_{C} vorgesehen sind, wobei der Ausgang des ersten Bandpassfilters (1) mit dem Eingang des zweiten Bandpassfilters (2) mittels eines Mischers (3) gekoppelt ist und der lokale Oszillator (4) zur Steuerung des Mischers (3) vorgesehen ist.

2. Filteranordnung nach Anspruch 1,
**dadurch gekennzeichnet,**
**dass** die Frequenz des Ausgangssignals (F₃) des lokalen Oszillators (4) variabel ist und dass vorgesehen ist, durch die Veränderung der Frequenz des Ausgangssignals (F₃) des lokalen Oszillators (4) die Bandbreite f_{B} und die Mittenfrequenz f_{C} des Ausgangssignals (F₂) der Filteranordnung zu variieren.

3. Filteranordnung nach Anspruch 2,
**dadurch gekennzeichnet,**
**dass** diese zur Wahl der Zwischenfrequenz bei Quadraturamplitudenmodulation vorgesehen ist.

4. Filteranordnung nach Anspruch 1,
**dadurch gekennzeichnet,**
**dass** die Bandpassfilter (1, 2) eine feste Bandbreite f_{B} aufweisen.
